Europäisches Patentamt

European Patent Office

Office européen des brevets

(11) Veröffentlichungsnummer: **0 418 869 A2**

## (12) EUROPÄISCHE PATENTANMELDUNG

(21) Anmeldenummer: **90118044.8**

(22) Anmeldetag: **19.09.90**

(51) Int. Cl.5: **H05K 7/16**

(30) Priorität: **21.09.89 DE 8911274 U**

(43) Veröffentlichungstag der Anmeldung:
**27.03.91 Patentblatt 91/13**

(84) Benannte Vertragsstaaten:
**AT BE CH DE FR GB IT LI NL**

(71) Anmelder: **Siemens Aktiengesellschaft**
**Wittelsbacherplatz 2**
**W-8000 München 2(DE)**

(72) Erfinder: **Müller, Walter**
**Parkstrasse 5**
**W-8902 Neusäss(DE)**

(54) **Unternetzverteilergehäuse.**

(57) Unternetzverteilergehäuse mit einer ersten Einbauebene in Form einer in der Nähe der einen Vorderkante schwenkbar angeordneten Klappe, einer zweiten Einbauebene in Form einer im Inneren des Gehäuses angeordneten ersten Montage platte und einer dritten Einbauebene in Form einer im geringen Abstand parallel zur ersten Montageplatte angeordneten zweiten Montageplatte.

Xerox Copy Centre

EP 0 418 869 A2

## UNTERNETZVERTEILERGEHÄUSE

Für elektronische Geräte, z.B. von Datenverarbeitungsanlagen, werden zur Stromverteilung und zur Aufnahme diverser Bauteile bzw. Baugruppen, Gehäuse als sogenannte Unternetzverteiler benötigt. Diese Gehäuse sollen platzsparend und für eventuell auszuführende Wartungsarbeiten nur von der Gehäusevorder- bzw. -rückseite zugänglich sein. Die Leitungsführung und die Anordnung der Bauteile in einem solchen Unternetzverteilergehäuse soll so ausgeführt sein, daß Nachrüstungen und Austausch von Bauelementen problemlos durchgeführt werden können. Ferner ist eine gute Übersichtlichkeit der Leitungsführung und der von außen zu bedienenden Bauelemente, wie z.B. Sicherungsautomaten, erforderlich. Das Gehäuse soll ferner so konzipiert sein, daß nach dem Abnehmen von Abdeckungen eine größtmögliche Zugänglichkeit gewährleistet ist. Alle Baugruppen und Bauteile eines Unternetzverteilers einschließlich Netzfiltern sollen in einem einzigen Gehäuse vormontiert und als komplette Baugruppe in das elektronische Gerät eingehängt werden können.

Gemäß der Erfindung wird diese Aufgabe gelöst durch ein Unternetzverteilergehäuse mit drei Einbauebenen zur Aufnahme von Bauteilen und Baugruppen, wobei die erste Einbauebene durch eine in der Nähe der einen Vorderkante schwenkbar angeordnete Klappe, die zweite Einbauebene durch eine im Inneren des Gehäuses angeordnete erste Montageplatte und die dritte Einbauebene durch eine im geringem Abstand parallel zu ersten Montageplatte angeordnete zweite Montageplatte gebildet ist.

Eine besonders optimale Anordnung der Bauteile und Baugruppen sowie eine gute Übersichtlichkeit derselben und der Leitungsführung wird erreicht, wenn auf der schwenkbaren Klappe Sicherungsautomaten und Masseanschlußklemmen sowie gegebenenfalls eine Steckdose für Wartungszwecke, auf der ersten Montageplatte Relais und Flachbaugruppen und auf der zweiten Montageplatte Schütze, Netzfilter und Netzüberwachungsbaugruppen angeordnet sind.

Weitere Einzelheiten der Neuerung ergeben sich aus den Schutzansprüchen sowie der nachfolgenden Beschreibung eines vorteilhaften Ausführungsbeispiels.

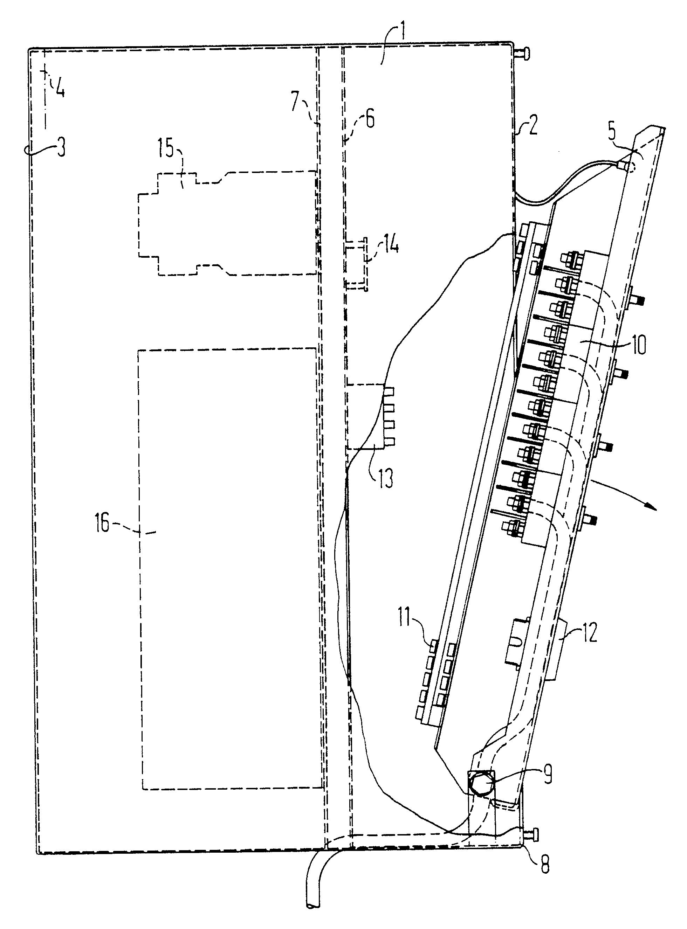

Das in der Zeichnung dargestellte Ausführungsbeispiel des neuerungsgemäßen Unternetzverteilergehäuses besteht aus einem Gehäusegrundkörper 1, der an der Vorderseite 2 sowie an der Rückseite 3 jeweils durch eine Abdeckung - die hier der Übersichtlichkeit halber nicht dargestellt ist - abgedeckt werden kann. In der Nähe der Vorderseite 2 des Gehäuses 1, insbesondere direkt hinter der unteren Vorderkante 8 des Gehäuses 1, ist in dessen Inneren eine aus der senkrechten Lage um 90° nach unten schwenkbare Klappe 5 angeordnet. Diese Klappe 5 bildet die erste Einbauebene des Unternetzverteilergehäuses. Auf ihr sind vorteilhafterweise die Sicherungsautomaten 10 und Masseanschlußklemmen 11 sowie gegebenenfalls eine Steckdose 12 für Wartungszwecke angeordnet.

Im Inneren des Gehäuses 1 befindet sich eine erste Montageplatte 6, die die zweite Einbauebene des Unternetzverteilergehäuses bildet, und parallel dazu in unmittelbarer Nähe der ersten Nontageplatte und damit der zweiten Einbauebene befindet sich eine zweite Montageplatte 7, die die dritte Einbauebene des neuerungsgemäßen Unternetzverteilergehäuses bildet. Auf der ersten Montageplatte 6 werden Relais 13 und Flachbaugruppen 14 und auf der zweiten Montageplatte 7 werden Schütze 15, Netzfilter 16 und Netzüberwachungsbaugruppen angeordnet.

Wie aus der Zeichnung ersichtlich ist, sind alle Einbauebenen des neuerungsgemäßen Unternetzverteilergehäuses leicht zugänglich. Die erste Einbauebene, gebildet durch die Klappe 5 ist leicht zugänglich, wenn die Klappe um 90° nach unten geschwenkt wird. In diesem Zustand ist auch die zweite, im Inneren des Gehäuses 1 befindliche Einbauebene - gebildet durch die erste Montageplatte 6 - leicht zugänglich. Die dritte Einbauebene gebildet durch die zweite Montageplatte 7 - ist jederzeit zugänglich, wenn die an der Rückseite 3 des Gehäuses 1 angeordnete Abdeckung 4 (nur schematisch angedeutet) abgenommen wird. Somit sind alle Ebenen und die auf ihnen befestigten Bauteile und Baugruppen der zugrundeliegenden Aufgabe entsprechend frei zugänglich und für einen eventuellen Bauelemente- bzw. Baugruppenaustausch problemlos erreichbar. Da alle Bauelemente und Baugruppen entweder von der Vorderseite 2 des Gehäuses oder von dessen Rückseite 3 aus zugänglich sind, kann das neuerungsgemäße Unternetzverteilergehäuse an den dafür vorgesehenen Schränken der elektronischen Geräte seitlich angebracht werden, ohne daß die Zugänglichkeit zu den Baugruppen und Bauelementen beeinträchtigt ware. Damit kann der Unternetzverteiler in seinem Gehäue vormontiert und als komplette Baueinheit in ein elektronisches Gerät, wie z.B. eine Datenverarbeitungsanlage, eingehängt werden.

**Ansprüche**

1. Unternetzverteilergehäuse, insbesondere für Geräte der Datenverarbeitung, mit einer vorderen und einer hinteren Abdekkung, **gekennzeichnet durch** drei Einbauebenen zur Aufnahme von Bauteilen und Baugruppen, wobei die erste Einbauebene durch eine in der Nähe der einen Vorderkante (8) schwenkbar angeordnete Klappe (5), die zweite Einbauebene durch eine etwa mittig im Inneren des Gehäuses angeordnete erste Montageplatte (6) und die dritte Einbauebene durch eine im geringen Abstand parallel zur ersten Montageplatte (6) angeordnete zweite Montageplatte (7) gebildet ist.

2. Unternetzverteilergehäuse nach Anspruch 1, **dadurch gekennzeichnet,** daß die die erste Einbauebene bildende Klappe (5) direkt hinter der unteren Vorderkante (8) im Inneren des Gehäuses (1) um 90° nach unten schwenkbar gelagert ist (9).

3. Unternetzverteilergehäuse nach Anspruch 1 oder 2, **dadurch gekennzeichnet,** daß auf der schwenkbaren Klappe (5) Sicherungsautomaten und Masseanschlußklemmen sowie gegebenenfalls eine Steckdose für Wartungszwecke, auf der ersten Montageplatte (6) Relais und Flachbaugruppen und auf der zweiten Montageplatte (7) Schütze, Netzfilter und Netzüberwachungsbaugruppen angeordnet sind.

EP 0 418 869 A2

4